# FASCICULE DE BREVET EUROPEEN

(11) **EP 2 784 813 B1**
(45) Date de publication et mention de la délivrance du brevet: **26.10.2016**
(21) Numéro de dépôt: 14160814.1
(22) Date de dépôt: 20.03.2014
(51) Int. Cl.: H01L 23/498, H01L 25/00

(54) **Support pour auto-assemblage capillaire avec stabilisation horizontale, procédé de fabrication et utilisation**
Ständer für kapillare Selbstorganisation mit horizontaler Stabilisierung, Herstellungsverfahren und Verwendung
Support for capillary self-assembly with horizontal stabilisation, manufacturing method and use

(30) Priorité: 25.03.2013 FR 1352657
(43) Date de publication de la demande: 01.10.2014
(73) Titulaire: Commissariat à l'Énergie Atomique et aux Énergies Alternatives, 75015 Paris (FR); STMicroelectronics (Crolles 2) SAS, 38920 Crolles (FR)
(72) Inventeur: Berthier, Jean, 38240 Meylan (FR); Di Cioccio, Léa, 38330 Saint Ismier (FR); Mermoz, Sébastien, 38240 Meylan (FR)
(74) Mandataire: Ilgart, Jean-Christophe

(56) Documents cités:
- WO-A1-2011/132630
- JP-A- 2005 317 694
- BERTHIER J ET AL: "Self-alignment of silicon chips on wafers: A capillary approach", JOURNAL OF APPLIED PHYSICS, AMERICAN INSTITUTE OF PHYSICS. NEW YORK, US, vol. 108, no. 5, 9 septembre 2010 (2010-09-09), pages 54905-54905, XP012142845, ISSN: 0021-8979, DOI: 10.1063/1.3466782
- TAKAFUMI FUKUSHIMA ET AL: "Self-Assembly of Chip-Size Components with Cavity Structures: High-Precision Alignment and Direct Bonding without Thermal Compression for Hetero Integration", MICROMACHINES, vol. 2, no. 4, 18 février 2011 (2011-02-18), pages 49-68, XP055074309, DOI: 10.3390/mi2010049

## Description

### DOMAINE TECHNIQUE

Le domaine de l'invention concerne la création de structures par auto-assemblage capillaire de structures mésoscopiques. Les principales applications de cette technique sont la microélectronique 3D (pour laquelle on cherche à empiler verticalement, puis sceller, des puces électroniques), l'optique (notamment l'alignement de diodes électroluminescentes ou de micro-miroirs), et enfin le packaging de microsystèmes électromécaniques (MEMS pour *MicroElectroMechanical Systems*) ou de microsystèmes fluidiques (pour lesquels on cherche à placer précisément une plaque de couverture afin de la sceller sur le système).

### ÉTAT DE LA TECHNIQUE ANTÉRIEURE

La technique d'auto-assemblage capillaire d'objets de taille mésoscopique - par exemple comme décrit dans le document WO2011/132630 - repose sur l'utilisation des forces capillaires pour déplacer un objet dans un alignement prédéfini. Selon cette technique, une plaque (ou encore une puce ou pastille) mobile de forme quelconque est placée sur une gouttelette liquide préalablement déposée sur un support fixe de forme correspondante. Les forces capillaires créées par l'ancrage du liquide sur les arêtes de la plaque mobile et du support sont utilisées pour aligner la plaque mobile exactement au dessus du support. L'enveloppe de la plaque mobile flottante est alors l'image exacte de l'enveloppe support, translatée verticalement vers le haut.

Dans le cas où le liquide est de l'eau, l'évaporation aboutit au contact de la plaque et du support, qui se scellent ensemble par contact direct. C'est le cas de la microélectronique 3D ou encore du packaging des MEMS ou des labs-on-chip.

Dans le cas où le liquide est un corps chimique qui se solidifie, la plaque est fixée dans un emplacement bien contrôlé. C'est le cas des applications optiques notamment.

En prenant certaines précautions, comme par exemple un bon mouillage des deux facettes (plaque et support) en en maîtrisant l'ancrage sur les arêtes, un assez bon taux de succès de l'alignement peut être obtenu. Néanmoins, pour l'industrialisation, ce taux de succès doit atteindre des niveaux très élevés.

Des études (voir par exemple l'article de J.Berthier et al. intitulé « Self-alignment of silicon chips on wafers: A capillary approach", J. Appl. Phys. 108, 054905, 2010) ont montré que le mouvement de la plaque sur le film liquide pouvait se décomposer en quatre modes: la translation latérale (*shift*), la rotation d'axe vertical (*twist*), la translation verticale (*lift*) et le basculement d'axe horizontal (*tilt*). Il a été établi que tous ces modes sont stables, c'est-à-dire qu'ils ramènent la puce dans l'alignement, sauf le tilt qui est légèrement instable. En d'autres termes, la plaque mobile peut s'incliner lentement et progressivement sur la goutte jusqu'à venir toucher le support.

Ces études ont été confirmées par des observations expérimentales. En ce qui concerne la microélectronique 3D, il a été remarqué que le tilt pouvait provoquer un contact mécanique entre la plaque (puce) et le support, bloquant le mouvement d'alignement de la plaque. En ce qui concerne les applications dans le domaine optique où le liquide intermédiaire se solidifie progressivement, le tilt provoque un mauvais alignement horizontal de la plaque, nuisible à la qualité optique.

La prise en compte des modes de déplacement de la plaque est fondamentale: en effet, au moment de la dépose de la plaque sur la gouttelette, il y a donc toujours un défaut d'alignement initial composé à la fois d'un shift, twist, lift et tilt initial. La méthode d'auto-assemblage capillaire repose sur la résorption de ces défauts initiaux. Or le fait que le tilt soit instable, même seulement légèrement, pose un problème qu'il est essentiel de résoudre.

Outre le tilt, d'autres causes de mauvais alignement ont été observées : un débordement intempestif du liquide qui empêche l'ancrage du fluide sur les arêtes, un défaut de mouillage de la plaque, et éventuellement un phénomène dynamique lié à la dépose de la puce. Et jusqu'à présent, à part une amélioration de l'horizontalité de la plaque au moment de la dépose sur la goutte, aucune autre solution développable industriellement n'a été proposée pour résoudre le problème d'alignement lié au tilt.

### EXPOSÉ DE L'INVENTION

L'invention a pour objectif d'améliorer l'alignement de la plaque et du support et propose pour ce faire un support comportant une zone de réception dont l'enveloppe externe correspond à la forme d'une plaque destinée à être posée sur une gouttelette placée au moins dans la zone de réception afin de réaliser l'auto-assemblage capillaire de la plaque et du support, et au moins une paire de pistes qui s'étendent sur le support depuis de la zone de réception et qui présentent une affinité de type lyophile avec la gouttelette de sorte qu'un débordement de la gouttelette en dehors de la zone de réception est canalisé dans les pistes, caractérisé en ce que l'au moins une paire de pistes comprend une première piste et une deuxième piste qui ne présentent pas le même degré d'affinité de type lyophile avec la gouttelette.

Le fait qu'un débordement incontrôlé conduit à un mauvais alignement a produit l'idée fausse que tout débordement était nuisible. C'est pourquoi les équipes travaillant sur cette problématique ont adopté pour principe de chercher à juguler tout débordement. L'approche préconisée par l'invention va dans une autre direction : grâce à l'au moins une piste lyophile, on induit un débordement contrôlé qui permet de maîtriser le tilt, tout en conservant les effets qui conduisent à l'alignement.

Par ailleurs, en ayant recours à des pistes ne présentant pas le même degré d'affinité de type lyophile avec la gouttelette, il s'avère possible de conférer à la plaque une inclinaison donnée par rapport à l'horizontale (c'est-à-dire un tilt).

Certains aspects préférés mais non limitatifs de ce support sont les suivants :
- l'au moins une paire de pistes et une partie au moins de la zone de réception présentent une affinité de type lyophile avec la gouttelette ;
- la première piste et la deuxième piste s'étendent de part et d'autre de la zone de réception dans le prolongement l'une de l'autre selon une même direction ;
- il comprend comprenant au moins deux paires de pistes s'étendant dans le plan du support, par exemple selon des directions sensiblement perpendiculaires ;
- il comprend une pluralité de motifs contigus, où chaque motif est délimité par un pourtour à l'intérieur duquel est circonscrite l'enveloppe externe d'une zone de réception, l'au moins une paire de pistes s'étendant de la zone de réception jusqu'au pourtour du motif;
- la première et la deuxième piste ne présentent pas la même largeur;
- la première et la deuxième piste sont réalisées en des matériaux différents ;
- il comprend un dispositif électro-capillaire associé à chacune des pistes de manière à pouvoir en modifier le degré d'affinité de type lyophile avec la gouttelette ;

L'invention porte également sur un procédé d'auto-assemblage capillaire d'une plaque sur un support selon le premier aspect de l'invention, comportant les étapes de placement d'une gouttelette au moins dans la zone de réception du support, et de pose de la plaque sur la gouttelette. Le support peut présenter une pluralité de motifs, où chaque motif est délimité par un pourtour à l'intérieur duquel est circonscrite l'enveloppe externe d'une zone de réception, l'au moins une paire de pistes s'étendant de la zone de réception jusqu'au pourtour du motif, et le procédé comprend un mouillage global du support pour venir placer une gouttelette dans chacune des zones de réception. Le procédé peut par ailleurs comprendre la pose collective d'une pluralité de plaques.

Et l'invention s'étend également à un procédé de formation d'un support comportant une zone de réception dont l'enveloppe externe correspond à la forme d'une plaque destinée à être posée sur une gouttelette placée dans la zone de réception afin de réaliser l'auto-assemblage capillaire de la plaque et du support, caractérisé en ce qu'il comporte la formation d'au moins une paire de pistes s'étendant sur le support depuis la zone de réception et présentant une affinité de type lyophile avec la gouttelette de sorte qu'un débordement de la gouttelette en dehors de la zone de réception est canalisé dans les pistes, l'au moins une paire de pistes comprenant une première piste et une deuxième piste qui ne présentent pas le même degré d'affinité de type lyophile avec la gouttelette.

Ce procédé peut également comprendre la formation de la première piste et de la deuxième piste de manière à ce qu'elles s'étendent de part et d'autre de la zone de réception dans le prolongement l'une de l'autre, lesdites première et deuxième pistes n'étant pas soumises à un même traitement de surface afin de leur conférer un degré d'affinité de type lyophile avec la gouttelette différent à chacune d'entre elles.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- les figures 1a et 1b représentent de manière schématique des supports selon des modes de réalisation possible de l'invention ;
- les figures 2a et 2b représentent les supports des figures 1a et 1b respectivement sur lesquels une gouttelette a été déposée ;
- les figures 3a et 3b illustrent l'auto-alignement capillaire d'une plaque déposée sur les supports des figures 1a et 1b respectivement ;
- la figure 3c illustre la résorption d'un mouvement de tilt initial d'une plaque déposée sur le support de la figure 1a ;
- les figures 4a et 4b sont des schémas illustrant un contrôle du tilt conformément à l'invention ;
- les figures 5a et 5b représentent des modes de réalisation possibles de supports multi-motifs conformes à un mode de réalisation possible de l'invention ;
- les figures 6a et 6b représentent des configurations selon lesquelles les gouttelettes déposées sur un support multi-motifs sont séparées ou respectivement se touchent ;
- la figure 7 représente de manière schématique différentes étapes d'un procédé de formation d'un support conforme à l'invention.

### EXPOSÉ DÉTAILLÉ DE MODES DE RÉALISATION PARTICULIERS

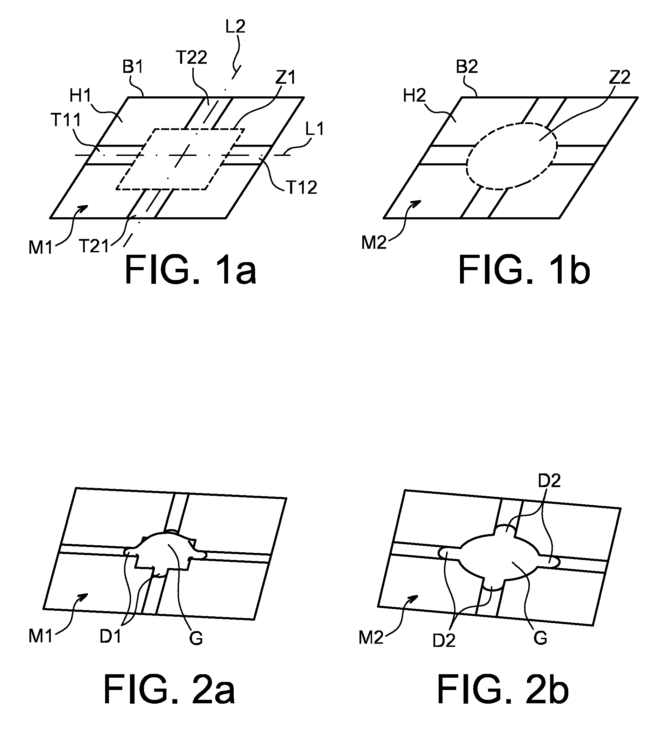

Selon un premier aspect, et en référence aux figures 1a-1b, 2a-2b et 3a-3c, l'invention concerne un support comprenant une zone de réception Z1, Z2 dont l'enveloppe externe correspond à la forme d'une plaque P1, P2 destinée à être posée sur une gouttelette G placée au moins dans la zone de réception afin de réaliser l'auto-assemblage capillaire de la plaque et du support.

A titres d'exemple purement illustratif, la plaque P1 prend par exemple la forme d'un carré, de sorte que l'enveloppe externe de la zone de réception Z1 est également carrée (figures 1a, 2a et 3a). Dans un autre exemple, la plaque P2 est circulaire, et l'enveloppe externe de la zone de réception Z2 est donc également circulaire (figures 1b, 2b et 3b).

Sur les figures, la forme de la zone de réception Z1, Z2 correspond à la forme de la plaque P1, P2. L'invention n'est pas limitée à ce cas de figure, et s'étend également à des objets de forme plus complexe, comme des plaques dans la face libre desquelles une ou plusieurs cavités sont pratiquées et des supports correspondants dont la zone de réception comprend une ou plusieurs régions d'assemblage sur lesquelles la face libre de la plaque va être alignée, la ou les régions d'assemblage prenant par exemple la forme de plateaux dépassant de la surface d'un substrat, la ou les cavités venant en regard de la surface du substrat et à distance de celle-ci. On trouvera un exemple d'une telle forme complexe dans l'article de Fukushima T. et al. intitulé "Self-Assembly of Chip-Size Components with Cavity Structures: High-Precision Alignment and Direct Bonding without Thermal Compression for Hetero Integration", Micromachines. 2011; 2(1):49-68.

Les régions de la plaque et du support destinées à être assemblées par capillarité sont lyophiles, en ce sens qu'elles présentent une affinité avec le liquide de la gouttelette. Ces régions sont ainsi hydrophiles lorsque le liquide est aqueux. La zone de réception du support présente ainsi au moins une région lyophile (la ou les régions de d'assemblage), l'intégralité de la zone de réception étant lyophile dans le cas des formes simples représentées sur les figures.

Dans le cadre de l'invention, on prévoit une structure auxiliaire dans le support, en dehors de la zone de réception Z1, Z2 dont l'enveloppe externe correspond à la forme de la plaque. Plus précisément, le support comporte au moins une paire de pistes T11, T12, T21, T22 s'étendant sur le support depuis la zone de réception Z1, Z2.

Les pistes présentent une affinité de type lyophile avec la gouttelette de sorte qu'un débordement de la gouttelette en dehors de la zone de réception Z1, Z2 est canalisé dans les pistes. On induit de la sorte un débordement contrôlé qui permet de maîtriser le tilt, tout en conservant les effets qui conduisent à l'alignement.

La présence des pistes définit un motif M1, M2 géométrique sur le support. Le motif M1, M2 est délimité par un pourtour B1, B2 à l'intérieur duquel est circonscrite l'enveloppe externe de la zone de réception Z1, Z2, les pistes s'étendant T11, T12, T21, T22 s'étendant de la zone de réception Z1, Z2 jusqu'au pourtour du motif. Dans les exemples des figures discutées ci-dessus, le motif M1, M2 est un carré de côté supérieur à la dimension caractéristique (côté dans le cas d'un carré, diamètre dans le cas d'un cercle) de la zone de réception Z1, Z2.

L'au moins une paire de pistes T11, T12, T21, T22 et une partie au moins de la zone de réception Z1, Z2 sont lyophiles, tandis que le reste du motif (c'est-à-dire l'extérieur de la zone de réception à l'exception de l'au moins une paire de pistes et, lorsque la zone de réception n'est pas intégralement lyophile, la partie non lyophile de la zone de réception) est lyophobe. Un contraste important de mouillabilité entre les régions lyophiles et lyophobes permet d'obtenir un fort taux de succès de l'alignement. Dans le cadre de l'invention, ce contraste important est assuré dès lors que l'angle de contact avec lequel la gouttelette repose sur les régions lyophiles et l'angle de contact avec lequel la gouttelette repose sur les régions lyophobes présentent un écart de plus de 40°, de préférence de plus de 50°. L'angle de contact sur les régions lyophiles est typiquement inférieur à 60°, tandis que l'angle de contact sur les régions lyophobes est typiquement supérieur à 100°, de préférence supérieur à 110°.

Comme représenté sur les figures, les pistes lyophiles peuvent être des pistes rectilignes. On peut par ailleurs prévoir d'associer les pistes d'une paire (T11 et T12 ; T21 et T22) selon une même direction (L1 ; L2) dans le prolongement l'une de l'autre respectivement de part et d'autre de la zone de réception.

On peut par ailleurs prévoir, comme représenté, deux paires de pistes rectilignes T11, T12; T21, T22 par motif qui s'étendent selon des directions indépendantes L1; L2 dans le plan du support afin d'assurer une maîtrise du tilt selon deux directions. Les deux paires de pistes peuvent notamment s'étendre selon des directions venant en intersection au centre la zone de réception, selon les diagonales du motif par exemple, ou encore selon des directions rectangulaires comme représenté sur les figures.

Les pistes s'étendent de la zone de réception jusqu'à la bordure du motif sur une longueur de piste. La largeur d'une piste est avantageusement comprise entre 1/6 et 1/4 de la dimension caractéristique de la plaque (diamètre pour une plaque circulaire, côté duquel part la portion de piste pour un objet polygonal). Ainsi, la piste n'est ni trop large (ce qui pourrait faire que les forces et couples d'alignement des autres modes, à savoir le shift et le twist, ne seraient plus suffisants pour réaliser l'alignement de la plaque et du support) ni trop étroite (auquel cas le liquide pourrait ne pas avancer sur la piste). Dans le cas où l'on souhaite que le débordement de la gouttelette canalisé dans une piste reste circonscrit dans le motif sans atteindre la bordure du motif, la longueur de la piste est supérieure à 3 fois la largeur de la piste, typiquement comprise entre 3 et 4 fois la largeur de la piste.

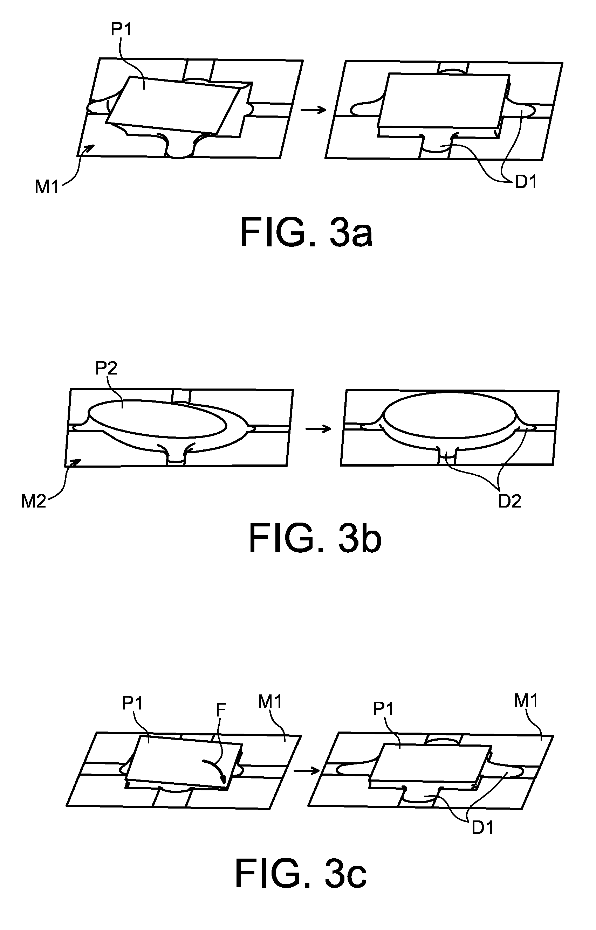

Les figures 2a-2b illustrent la formation de « doigts » liquides D1, D2 sur les pistes lyophiles suite au placement d'une gouttelette G de liquide. Comme on peut le constater des figures 3a-3b illustrant le réalignement capillaire d'une plaque P1, P2 suite à sa pose sur la gouttelette, les « doigts » liquides D1, D2 agissent comme des haubans qui, par la force capillaire qu'ils exercent, permettent de stabiliser la plaque horizontalement. Et comme on peut l'observer de la figure 3c, un mouvement de tilt (représenté par une flèche F sur la gauche de cette figure) de la plaque est résorbé grâce à la présence des pistes.

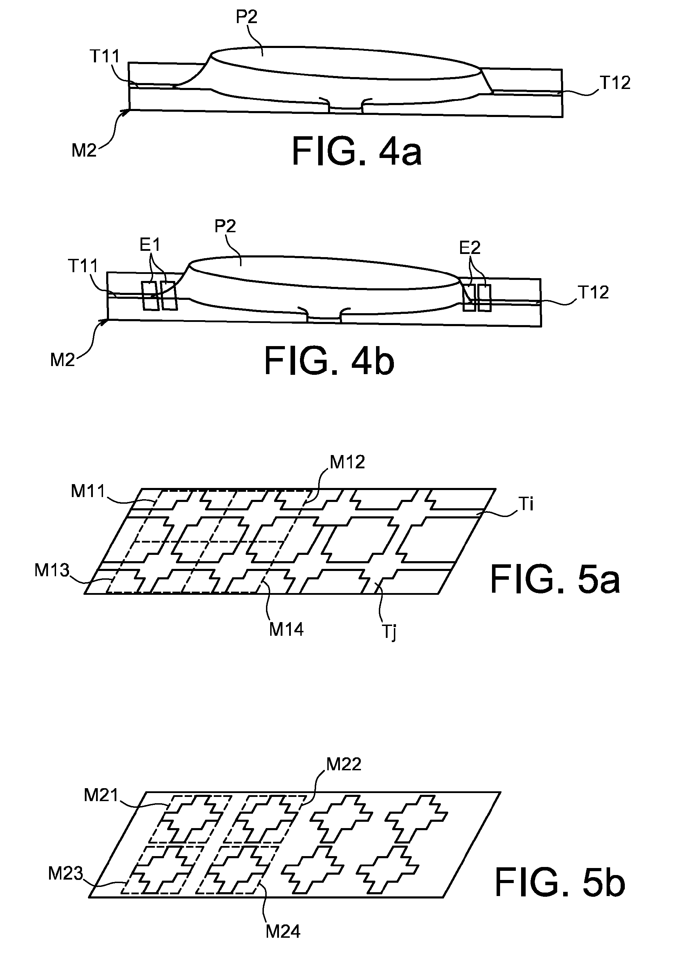

Selon l'invention, on vient donner à la plaque une inclinaison donnée par rapport à l'horizontale (c'est-à-dire un tilt). Pour ce faire, et en référence à la figure 4a, une piste T11 d'une paire de pistes et l'autre piste T12 de la paire de pistes ne présentent pas le même degré d'affinité de type lyophile avec la gouttelette. Le contraste de mouillabilité entre les pistes de la paire permet à titre d'exemple d'obtenir un tilt de 2° environ lorsque l'angle de contact est de 5° sur une piste T11 de la paire alors que l'angle de contact est de 40° sur l'autre piste T12 de la paire.

Dans l'exemple de la figure 4a, on a réalisé une inclinaison vers la droite, par rapport à un axe perpendiculaire à la direction L1 de la paire de pistes T11, T12. L'invention n'est bien entendu pas limitée au cas où un contraste de mouillabilité est donné aux pistes d'une seule paire, mais s'étend au cas où un tel contraste est également donné à une ou plusieurs autres paires de pistes. Ce faisant on peut modifier l'axe selon lequel s'opère l'inclinaison.

Dans une première variante, le contraste de mouillabilité est obtenu en faisant en sorte que les pistes T11 et T12 d'une paire de pistes s'étendant selon une même direction ne présentent pas la même largeur.

Dans une deuxième variante, le contraste de mouillabilité est obtenu en utilisant des matériaux différents pour les pistes T11 et T12 de la paire. A titre d'exemple, l'une des pistes peut être en silicium tandis que l'autre piste est en nitrure.

Dans une troisième variante, le contraste de mouillabilité est obtenu en ne soumettant pas les pistes T11 et T12 de la paire à un même traitement de surface visant à leur conférer ou à accentuer leur affinité de type lyophile avec la gouttelette. A titre d'exemple, l'une des pistes peut être soumise à un traitement plasma en accentuant le caractère lyophile, tandis que l'autre ne l'est pas.

Dans une quatrième variante illustrée par la figure 4b, un dispositif électro-capillaire est associé à chacune des pistes T11, T12 d'une paire de pistes de manière à pouvoir en modifier le degré d'affinité de type lyophile avec la gouttelette. Le dispositif électro-capillaire peut prendre la forme de paires d'électrodes E1, E2 disposées sous la surface du support de manière à permettre l'application d'une tension entre la gouttelette et chacune des pistes, la modification de la tension appliquée venant modifier l'angle de contact de la gouttelette sur la piste correspondante.

La réalisation d'une telle inclinaison de la plaque s'avère notamment intéressante dans le domaine de l'optofluidique où l'on cherche souvent à réaliser des micro-miroirs. Dans le cadre des variantes ci-dessus évoquées, une gélification du liquide conduit alors à un miroir fixe orienté. Dans le cadre de la quatrième variante, et pour autant que le liquide ne solidifie pas ni ne s'évapore comme un liquide organique, comme c'est le cas par exemple d'une huile de silicone, on peut réaliser un miroir orientable. Une LED orientée/orientable peut de la même manière être réalisée.

Dans un mode de réalisation de l'invention, le support présente une pluralité de motifs tels que décrit précédemment, les motifs étant typiquement disposés en lignes et colonnes. Ce mode de réalisation permet de réaliser la pose collective d'une pluralité de plaques sur le support, de la même manière que décrit par exemple dans l'article de Fukushima T. et al. intitulé "Development of a new self-assembled die bonder to three-dimensionally stack known good dies in batch", 3DIC, page 1-4. IEEE, (2009).

Comme représenté sur la figure 5a, les motifs M11, M12, M13, M14 peuvent être contigus. Ainsi, le support présente un ensemble de pistes Ti, Tj qui se prolongent d'un motif à l'autre continument sur toute la surface du support (la piste Ti se prolongeant par exemple du motif M11 au motif M12, etc.)

Alternativement, comme représenté sur la figure 5b, les motifs M21, M22, M23, M24 peuvent être disjoints. Dans un tel cas de figure, les pistes sont interrompues et ne viennent donc pas communiquer d'un motif à l'autre.

La configuration de la figure 5a à motifs contigus et pistes lyophiles continues présente l'avantage de permettre la réalisation d'un mouillage global du support en lieu et place d'un dépôt goutte à goutte des gouttelettes. Le mouillage global est suivi d'une évacuation capillaire du liquide en excès vers l'extérieur par les pistes lyophiles.

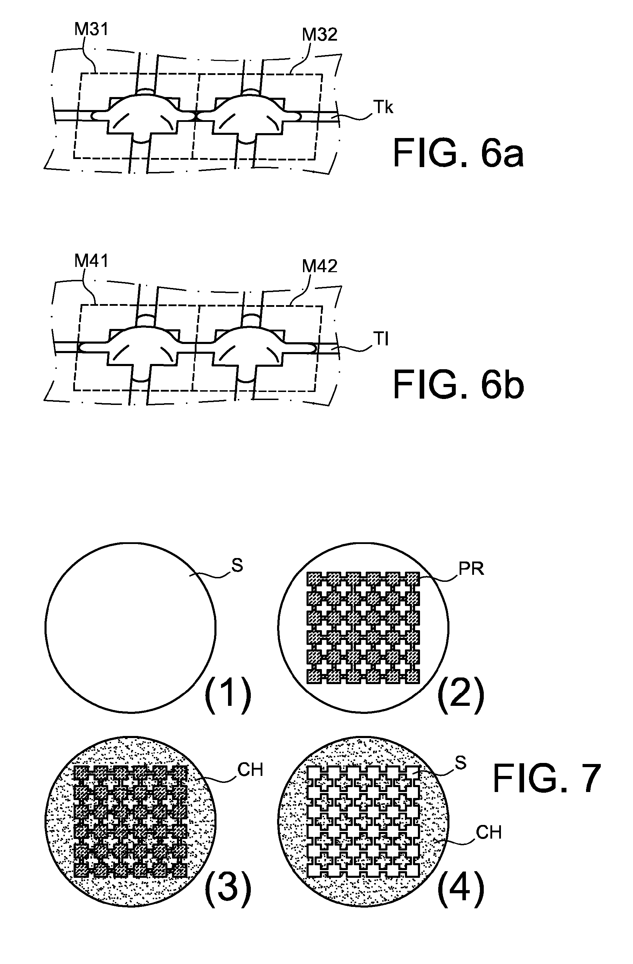

On a représenté sur la figure 6a une configuration des pistes lyophiles telles que les gouttelettes déposées respectivement dans la zone de réception circonscrite dans les motifs M31 et M32 restent séparées les unes des autres. A contrario, la figure 6b illustre une configuration dans laquelle les gouttelettes se rejoignent, de sorte à obtenir une continuité du liquide sur les zones lyophiles (zones de réception et pistes) du support. Le dimensionnement adéquat des pistes lyophiles pour assurer une telle communication des gouttelettes peut être calculé au moyen du logiciel Surface Evolver, et prend en compte les paramètres suivants : volume des gouttelettes, angle de contact sur les zones lyophiles, tension de surface, longueur et largeur des pistes, masse de la plaque.

L'invention s'étend ainsi à un procédé d'auto-assemblage capillaire d'une plaque sur un support tel que décrit précédemment, comportant les étapes de placement d'une gouttelette au moins dans la zone de réception du support, et de pose de la plaque sur la gouttelette.

Le support peut notamment présenter une pluralité de zones de réception, et le placement des gouttelettes peut être réalisé par dépôt goutte à goutte (en évitant le contact entre les gouttes) ou par mouillage global. On réalise alors avantageusement la pose collective, et ainsi l'auto-assemblage collectif, d'une pluralité de plaques sur le support.

L'invention s'étend par ailleurs à un procédé de formation d'un support comprenant une zone de réception dont l'enveloppe externe correspond à la forme d'une plaque destinée à être posée sur une gouttelette placée dans la zone de réception afin de réaliser l'auto-assemblage capillaire de la plaque et du support. Le procédé comprend la formation d'au moins une paire de pistes s'étendant sur le support depuis la zone de réception, les pistes présentant une affinité de type lyophile avec la gouttelette de sorte qu'un débordement de la gouttelette en dehors de la zone de réception est canalisé dans l'au moins une piste, l'au moins une paire de pistes comprenant une première piste et une deuxième piste qui ne présentent pas le même degré d'affinité de type lyophile avec la gouttelette.

Un exemple d'un tel procédé est le suivant. En référence à la figure 7, on dispose (1) d'un support de type substrat S en silicium, de diamètre 200 ou 300 mm. On applique une photorésine PR sur le substrat, puis on expose la photorésine à une exposition lumineuse avec un masquage adapté pour que la photorésine PR recouvre (2) les portions du support destinées à former les (régions d'assemblage des) zones de réception et (la ou) les pistes hydrophiles. On procède ensuite à la formation (3) d'une couche hydrophobe CH sur le substrat, par exemple par dépôt (par exemple d'une couche carbonée, d'un couche d'octafluorobutène C4F8 ou d'une couche de téflon) ou par traitement de surface (par exemple un traitement de rugosification de surface tel qu'une gravure chimique). On procède ensuite au retrait (4) de la photorésine PR (par exemple au moyen d'un solvant, ou par traitement plasma, ou encore par nettoyage) de manière à exposer par effet de « lift-off » des portions non hydrophobes du substrat S correspondant aux (régions d'assemblage des) zones de réception et aux pistes hydrophiles. Une fois le silicium mis à jour, on peut lui appliquer un traitement visant à le rendre très hydrophile (par exemple par plasma, brossage, traitement UV/ozone), sans pour autant altérer la couche hydrophobe déposée au préalable. On peut de la sorte obtenir des zones extrêmement hydrophiles (angle de contact inférieur à 5°, alors qu'il est de l'ordre de 40° en l'absence d'un traitement accentuant le caractère hydrophile) entourées de zones très hydrophobes (angle de contact supérieur à 100°).

Dans le cadre de ce procédé, les pistes lyophiles sont formées en même temps que les (régions d'assemblage des) zones de réception. La formation de ces pistes lyophiles n'apporte donc pas de complications supplémentaires lors de la fabrication.

## Revendications

1. Support comportant une zone de réception (Z1, Z2) dont l'enveloppe externe correspond à la forme d'une plaque (P1, P2) destinée à être posée sur une gouttelette (G) placée au moins dans la zone de réception afin de réaliser l'auto-assemblage capillaire de la plaque et du support, et au moins une paire de pistes (T11, T12 ; T21, T22) qui s'étendent sur le support depuis de la zone de réception (Z1, Z2) et qui présentent une affinité de type lyophile avec la gouttelette de sorte qu'un débordement de la gouttelette en dehors de la zone de réception est canalisé dans les pistes, **caractérisé en ce que** l'au moins une paire de pistes comprend une première piste (T11) et une deuxième piste (T12) qui ne présentent pas le même degré d'affinité de type lyophile avec la gouttelette.

2. Support selon la revendication 1, dans lequel l'au moins une paire de pistes (T11, T12 ; T21, T22) et une partie au moins de la zone de réception (Z1, Z2) présentent une affinité de type lyophile avec la gouttelette.

3. Support selon l'une des revendications 1 et 2, dans lequel la première piste et la deuxième piste s'étendent de part et d'autre de la zone de réception dans le prolongement l'une de l'autre selon une même direction (L1; L2).

4. Support selon la revendication 3, comprenant au moins deux paires de pistes s'étendant (T11, T12 ; T21, T22) dans le plan du support.

5. Support selon la revendication 4, comprenant deux paires de pistes (T11, T12 ; T21, T22) s'étendant selon des directions sensiblement perpendiculaires dans le plan du support.

6. Support selon l'une des revendications 1 à 5, comprenant une pluralité de motifs (M11, M12, M13, M14) contigus, où chaque motif est délimité par un pourtour (B1, B2) à l'intérieur duquel est circonscrite l'enveloppe externe d'une zone de réception (Z1, Z2), l'au moins une paire de pistes (T11, T12, T21, T22) s'étendant de la zone de réception jusqu'au pourtour du motif.

7. Support selon l'une des revendications 1 à 6, dans lequel la première (T11) et la deuxième (T12) pistes ne présentent pas la même largeur.

8. Support selon l'une des revendications 1 à 6, dans lequel la première (T11) et la deuxième (T12) pistes sont réalisées en des matériaux différents.

9. Support selon l'une des revendications 1 à 8, comprenant un dispositif électro-capillaire (E1, E2) associé à chacune des pistes de manière à pouvoir en modifier le degré d'affinité de type lyophile avec la gouttelette.

10. Procédé d'auto-assemblage capillaire d'une plaque sur un support selon l'une des revendications 1 à 9, comportant les étapes de :
- placement d'une gouttelette au moins dans la zone de réception du support ;
- pose de la plaque sur la gouttelette.

11. Procédé selon la revendication 10, dans lequel le support présente une pluralité de motifs, où chaque motif est délimité par un pourtour (B1, B2) à l'intérieur duquel est circonscrite l'enveloppe externe d'une zone de réception (Z1, Z2), l'au moins une paire de pistes (T11, T12, T21, T22) s'étendant de la zone de réception jusqu'au pourtour du motif, et dans lequel on procède à un mouillage global du support pour venir placer une gouttelette dans chacune des zones de réception.

12. Procédé selon l'une des revendications 10 et 11, dans lequel le support présente une pluralité de motifs, où chaque motif est délimité par un pourtour (B1, B2) à l'intérieur duquel est circonscrite l'enveloppe externe d'une zone de réception (Z1, Z2), l'au moins une paire de pistes (T11, T12, T21, T22) s'étendant de la zone de réception Z1, Z2 jusqu'au pourtour du motif, et dans lequel on procède à la pose collective d'une pluralité de plaques.

13. Procédé de formation d'un support comportant une zone de réception (Z1, Z2) dont l'enveloppe externe correspond à la forme d'une plaque (P1, P2) destinée à être posée sur une gouttelette placée dans la zone de réception afin de réaliser l'auto-assemblage capillaire de la plaque et du support, **caractérisé en ce qu'**il comporte la formation d'au moins une paire de pistes (T11, T12 ; T21, T22) s'étendant sur le support depuis la zone de réception (Z1, Z2) et présentant une affinité de type lyophile avec la gouttelette de sorte qu'un débordement de la gouttelette en dehors de la zone de réception est canalisé dans les pistes, l'au moins une paire de pistes comprenant une première piste (T11) et une deuxième piste (T12) qui ne présentent pas le même degré d'affinité de type lyophile avec la gouttelette.

14. Procédé selon la revendication 13, dans lequel on forme la première piste (T11) et la deuxième piste (T12) de manière à ce qu'elles s'étendent de part et d'autre de la zone de réception (Z1) dans le prolongement l'une de l'autre, et dans lequel lesdites première et deuxième pistes (T11, T12) ne sont pas soumises à un même traitement de surface de sorte qu'elles ne présentent pas le même degré d'affinité de type lyophile avec la gouttelette.

## Patentansprüche

1. Träger, umfassend einen Aufnahmebereich (Z1, Z2), dessen äußere Einhüllende der Form einer Platte (P1, P2) entspricht, die dazu bestimmt ist, auf einem Tröpfchen (G) positioniert zu werden, das wenigstens in dem Aufnahmebereich platziert ist, um die kapillare Selbstorganisation der Platte und des Trägers durchzuführen, und wenigstens ein Paar von Bahnen (T11, T12; T21, T22), die sich von dem Aufnahmebereich (Z1, Z2) aus über den Träger erstrecken, und die eine Affinität vom lyophilen Typ mit dem Tröpfchen zeigen, so dass ein Austreten des Tröpfchens aus dem Aufnahmebereich in die Bahnen kanalisiert wird, **dadurch gekennzeichnet, dass** das wenigstens eine Paar von Bahnen eine erste Bahn (T11) und eine zweite Bahn (T12) umfasst, die nicht das gleiche Ausmaß von Affinität vom lyophilen Typ mit dem Tröpfchen aufweisen.

2. Träger nach Anspruch 1, wobei das wenigstens eine Paar von Bahnen (T11, T12; T21, T22) und wenigstens ein Teil von dem Aufnahmebereich (Z1, Z2) eine Affinität vom lyophilen Typ mit dem Tröpfchen aufweisen.

3. Träger nach einem der Ansprüche 1 und 2, wobei die erste Bahn und die zweite Bahn sich zu beiden Seiten von dem Aufnahmebereich in der Verlängerung voneinander entlang einer gleichen Richtung (L1; L2) erstrecken.

4. Träger nach Anspruch 3, umfassend wenigstens zwei Paare von Bahnen (T11, T12; T21, T22), die sich in der Ebene des Trägers erstrecken.

5. Träger nach Anspruch 4, umfassend zwei Paare von Bahnen (T11, T12; T21, T22), die sich in der Ebene des Trägers entlang von Richtungen erstrecken, die im Wesentlichen orthogonal sind.

6. Träger nach einem der Ansprüche 1 bis 5, umfassend eine Mehrzahl von benachbarten Motiven (M11, M12, M13, M14), wobei jedes Motiv durch einen Rand (B1, B2) begrenzt ist, im Inneren dessen die äußere Einhüllende eines Aufnahmebereichs (Z1, Z2) eingegrenzt ist, wobei das wenigstens eine Paar von Bahnen (T11, T12; T21, T22) sich von dem Aufnahmebereich bis zum Rand des Motivs erstreckt.

7. Träger nach einem der Ansprüche 1 bis 6, wobei die erste (T11) und die zweite (T12) Bahn nicht die gleiche Breite aufweisen.

8. Träger nach einem der Ansprüche 1 bis 6, wobei die erste (T11) und die zweite (T12) Bahn aus verschiedenen Materialien hergestellt sind.

9. Träger nach einem der Ansprüche 1 bis 8, umfassend eine jeder der Bahnen zugeordnete elektrokapillare Einrichtung (E1, E2), so dass das Ausmaß von Affinität vom lyophilen Typ mit dem Tröpfchen davon modifiziert werden kann.

10. Verfahren zur kapillaren Selbstorganisation einer Platte auf einem Träger nach einem der Ansprüche 1 bis 9, umfassend die Schritte:
- Platzieren eines Tröpfchens wenigstens in dem Aufnahmebereich des Trägers,
- Positionieren der Platte auf dem Tröpfchen.

11. Verfahren nach Anspruch 10, wobei der Träger eine Mehrzahl von Motiven aufweist, wobei jedes Motiv durch einen Rand (B1, B2) begrenzt ist, im Inneren dessen die äußere Einhüllende von einem Aufnahmebereich (Z1, Z2) eingegrenzt ist, wobei das wenigstens eine Paar von Bahnen (T11, T12, T21, T22) sich von dem Aufnahmebereich bis zum Rand des Motivs erstreckt, und wobei eine globalen Befeuchtung des Trägers vorgenommen wird, um dazu zu kommen, ein Tröpfchen in jedem der Aufnahmebereiche zu platzieren.

12. Verfahren nach einem der Ansprüche 10 und 11, wobei der Träger eine Mehrzahl von Motiven aufweist, wobei jedes Motiv durch einen Rand (B1, B2) begrenzt ist, im Inneren dessen die äußere Einhüllende eines Aufnahmebereichs (Z1, Z2) eingegrenzt ist, wobei das wenigstens eine Paar von Bahnen (T11, T12, T21, T22) sich von dem Aufnahmebereich Z1, Z2 bis zum Rand des Motivs erstreckt, und wobei die gemeinsame Positionierung einer Mehrzahl von Platten vorgenommen wird.

13. Verfahren zur Bildung eines Trägers, umfassend einen Aufnahmebereich (Z1, Z2), dessen äußere Einhüllende der Form einer Platte (P1, P2) entspricht, die dazu bestimmt ist, auf einem Tröpfchen positioniert zu werden, das in dem Aufnahmebereich platziert ist, so dass die kapillare Selbstorganisation der Platte und des Trägers durchgeführt wird, **dadurch gekennzeichnet, dass** es die Bildung von wenigstens einem Paar von Bahnen (T11, T12; T21, T22) umfasst, die sich von dem Aufnahmebereich (Z1, Z2) aus über den Träger erstrecken und eine Affinität vom lyophilen Typ mit dem Tröpfchen aufweisen, so dass ein Austreten des Tröpfchens aus dem Aufnahmebereich in die Bahnen kanalisiert wird, wobei das wenigstens eine Paar von Bahnen eine erste Bahn (T11) und eine zweite Bahn (T12) umfasst, die nicht das gleiche Ausmaß von Affinität vom lyophilen Typ mit dem Tröpfchen aufweisen.

14. Verfahren nach Anspruch 13, wobei die erste Bahn (T11) und die zweite Bahn (T12) so gebildet werden, dass sie sich zu beiden Seiten des Aufnahmebereichs (Z1) in der Verlängerung voneinander erstrecken, und wobei die erste und zweite Bahn (T11, T12) nicht einer gleichen Oberflächenbehandlung unterzogen werden, so dass sie nicht das gleiche Ausmaß von Affinität vom lyophilen Typ mit dem Tröpfchen aufweisen.

## Claims

1. Support comprising a reception zone (Z1, Z2) which external envelope matches the shape of a plate (P1, P2) that is to be placed on a droplet (G) deposited at least in the reception zone in order to achieve capillary self-assembly of the plate and the support, and at least one pair of tracks (T11, T12; T21, T22) that extend on the support from the reception zone (Z1, Z2) and that have a lyophilic type affinity with the droplet such that an overflow of the droplet beyond the reception zone is guided in the tracks, **characterised in that** the at least one pair of tracks comprises a first track (T11) and a second track (T12) that do not have the same lyophilic type degree of affinity with the droplet.

2. Support according to claim 1, in which the at least one pair of tracks (T11, T12; T21, T22) and at least part of the reception zone (Z1, Z2) have a lyophilic type affinity with the droplet.

3. Support according to one of claims 1 and 2, in which the first track and the second track extend on each side of the reception zone prolonging each other along a single direction (L1; L2).

4. Support according to claim 3, comprising at least two pairs of tracks (T11, T12; T21, T22) extending in the support plane.

5. Support according to claim 4, comprising two pairs of tracks (T11, T12; T21, T22) extending along approximately perpendicular directions in the support plane.

6. Support according to one of claims 1 to 5, comprising a plurality of contiguous patterns (M11, M12, M13, M14), in which each pattern is delimited by a periphery (B1, B2) inside which the external envelope of a reception zone (Z1, Z2) is circumscribed, the at least one pair of tracks (T11, T12, T21, T22) extending from the reception zone as far as the periphery of the pattern.

7. Support according to one of claims 1 to 6, in which the first (T11) and the second (T12) tracks do not have the same width.

8. Support according to one of claims 1 to 6, in which the first (T11) and the second (T12) tracks are made from different materials.

9. Support according to one of claims 1 to 8, comprising an electro-capillary device (E1, E2) associated with each track so that the lyophilic type degree of affinity with the droplet can be modified.

10. Method for capillary self-assembly of a plate on a support according to one of claims 1 to 9, comprising steps to:
- deposit at least one droplet in the support reception zone;
- place the plate on the droplet.

11. Method according to claim 10, in which the support has a plurality of patterns, in which each patterns is delimited by a periphery (B1, B2) inside which the external envelope of a reception zone (Z1, Z2) is circumscribed, the at least one pair of tracks (T11, T12, T21, T22) extending from the reception zone as far as the periphery of the pattern, and in which global wetting of the support is done to place a droplet in each reception zone.

12. Method according to one of claims 10 and 11, in which the support has a plurality of patterns, in which each pattern is delimited by a periphery (B1, B2) to inside which the external envelope of a reception zone (Z1, Z2) is circumscribed, the at least one pair of tracks (T11, T12, T21, T22) extending from the reception zone Z1, Z2 as far as the periphery of the pattern, and in which a plurality of plates is collectively placed.

13. Method of forming a support comprising a reception zone (Z1, Z2) the external envelope of which matches the shape of a plate (P1, P2) that is to be placed on a droplet deposited in the reception zone for capillary self-assembly of the plate and the support, **characterised in that** it comprises the formation of at least one pair of tracks (T11, T12; T21, T22) extending on the support from the reception zone (Z1, Z2) and having a lyophilic type affinity with the droplet such that an overflow of the droplet outside the reception zone is guided in the tracks, the at least one pair of tracks comprising a first track (T11) and a second track (T12) that do not have the same lyophilic type degree of affinity with the droplet.

14. Method according to claim 13, which includes the formation of the first track (T11) and the second track (T12) such that they extend on each side of the reception zone (Z1) prolonging each other, and in which said first and second tracks (T11, T12) are not subjected to a same surface treatment such that they have a different lyophilic type degree of affinity with the droplet.
